# EUROPÄISCHE PATENTSCHRIFT

(11) **EP 1 478 063 B1**
(45) Veröffentlichungstag und Bekanntmachung des Hinweises auf die Patenterteilung: **10.01.2007**
(21) Anmeldenummer: 04011125.4
(22) Anmeldetag: 11.05.2004
(51) Int. Cl.: H01S 5/042, H05B 33/08

(54) **Treiberschaltung zum Betreiben eines elektronischen Bauteils**
Circuit for driving an electronic element
Circuit de commande pour élement electronique

(30) Priorität: 14.05.2003 DE 10323669
(43) Veröffentlichungstag der Anmeldung: 17.11.2004
(60) Teilanmeldung: 06017001.6
(73) Patentinhaber: ATMEL Germany GmbH, 74072 Heilbronn (DE)
(72) Erfinder: Bergmann, Günther Dr.-Ing., 89134 Blaustein (DE); Dotzauer, Erwin Dipl.-Ing., 87297 Roggenburg (DE); Knotz, Herbert Ing., 89155 Erbach (DE); Vogelmann, Holger Dipl.-Ing., 73066 Uhingen (DE); Wernig, Wolfgang Dipl.-Ing., 89134 Blaustein (DE)

(56) Entgegenhaltungen:
- EP-A- 0 707 255
- EP-A- 0 756 362
- EP-A- 0 810 700
- WO-A-03/034558
- US-A- 5 177 451
- US-A- 5 796 767
- PATENT ABSTRACTS OF JAPAN Bd. 2000, Nr. 19, 5. Juni 2001 (2001-06-05) -& JP 2001 036187 A (SONY CORP), 9. Februar 2001 (2001-02-09)
- PATENT ABSTRACTS OF JAPAN Bd. 017, Nr. 006 (E-1302), 7. Januar 1993 (1993-01-07) -& JP 04 239188 A (NEC CORP), 27. August 1992 (1992-08-27)
- PATENT ABSTRACTS OF JAPAN Bd. 018, Nr. 022 (E-1490), 13. Januar 1994 (1994-01-13) & JP 05 259546 A (NEC CORP), 8. Oktober 1993 (1993-10-08)
- PATENT ABSTRACTS OF JAPAN Bd. 017, Nr. 071 (E-1319), 12. Februar 1993 (1993-02-12) & JP 04 275473 A (SUMITOMO ELECTRIC IND LTD), 1. Oktober 1992 (1992-10-01)

## Beschreibung

Die Erfindung betrifft eine Treiberschaltung zum Betreiben eines elektronischen Bauteils mit einem elektrischen veränderlichen Strom, der in gesteuerter Weise zwischen wenigstens zwei diskreten Strömstarken umgesteuert wird, nach dem Oberbegriff des Patentanspruchs 1.

Laserdioden stellen ein Beispiel eines elektronischen Bauteils dar, das mit einer solchen Treiberschaltung betrieben wird.

Aus der EP 810 700 A2 ist eine Treiberschaltung zum Betreiben von Laserdioden bekannt, die Schaltungselemente aufweist, die Einschwingvorgänge dämpfen, die beim Umsteuern des elektrischen veränderliches Stroms zwischen den wenigstens zwei diskreten Stromstärken auftreten.

Auf Laserdioden basierende Halbleiterlaser werden beispielsweise zum Einschreiben von Daten in Speichermedien wie CD und DVD benutzt. Das Einschreiben, das mit hoher Geschwindigkeit stattfindet, erfordert optische Lichtpulse mit präziser zeitlicher Definition and präziser Leistung. Zur Erzeugung der Lichtleistung werden daher Ansteuerschaltungen benötigt, die Strompulse definierter Höhe und mit präzisem zeitlichen Verhalten abgeben können.

Bei der Erzeugung solcher Pulse stellt sich ganz allgemein das Problem, dass beim Umsteuern der Treiberspannung und/oder des Treiberstroms von einem ersten Niveau auf ein zweites Niveau Einschwingvorgänge (ringing) auftreten. Diese Einschwingvorgänge sind unerwünscht.

Das Ausmaß der bei Einschwingvorgängen auftretenden Abweichungen vom idealen Verlauf hängt von der Güte des angeregten Schwingkreises ab.

In der eingangs erwähnten EP 810 700 A2 wird die Schwingkreis-Güte durch Parallelschalten von R-C Bauelementen reduziert. Diese Maßnahme ist jedoch problematisch, weil sie die Anstiegs- bzw. Abfallgeschwindigkeit des Stromes stark reduziert. Ein weiterer Nachteil ist, dass die unvermeidbaren Gehäuse- und Bondkapazitäten weiterhin wirksam sind und die Wirksamkeit der vorgeschlagenen Maßnahmen reduzieren. Weiterhin erfordert die Realisierung des Vorschlags nicht unerheblich Chipfläche bei einer Ausführung der Treiberschaltung als integrierte Schaltung.

Aus JP 04 239188 A ist eine Treiberschaltung bekannt, die eine Stromspiegelschaltung mit einer ersten Reihenschaltung aus einem Referenzwiderstand und einem Referenztransistor sowie einer zweiten Reihenschaltung aus einem weiteren Widerstand und einem weiteren Transistor zwischen einem Versorgungsspannungsanschluss und einem Ausgang der Stromspiegelschaltung aufweist.

Aus JP 2001 036187 A ist eine Treiberschaltungen bekannt, die eine Strömspiegelschaltung mit einer ersten Reihenschaltung aus einem Referenzwiderstand und einem Referenztransistor zwischen einem Versorgungsspannungsanschluss und einer Steuerstromquelle sowie einer zweiten Reihenschaltung aus einem weiteren Widerstand und einem weiteren Transistor zwischen dem Versorgungsspannungsanschluss und einem Ausgang der Stromspiegelschaltung aufweist, wobei sowohl der Referenztransistor als auch der weitere Transistor durch eine gemeinsame Steuerstromquelle gesteuert werden.

Vor diesem Hintergrund besteht die Aufgabe der Erfindung in der Angabe einer Treiberschaltung mit reduzierten Einschwingvorgängen.

Diese Aufgabe wird durch die Merkmale des Patentanspruchs 1 gelöst.

Durch diese Merkmale wird die Aufgabe vollkommen gelöst.

Diese Merkmale stellen eine schaltungstechnische Maßnahme zur Realisierung eines frequenzabhängigen Spiegelfaktors K(f) dar. Sie verringert die effektive Kollektor-Basis Kapazität der Treiberschaltung substantiell.

Es hat sich gezeigt, dass die frequenzabhängige Realisierung des Spiegelfaktors in der Summe zu verringerten Einschwingvorgängen führt. Mit dem frequenzabhängigen Spiegelfaktor lassen sich insbesondere Laserdioden mit Strompulsen hoher Amplitude bis hin zu einigen hundert mA bei geringen Anstiegszeiten und Abfallzeiten im Bereich von weniger als einer Nanosekunde mit reduziertem Einschwingen (ringing) ansteuern.

Durch das Einfügen der Induktivität wird erreicht, dass der Verschiebungsstrom von der wirksamen Kollektor-Basis-Kapazität der Treiberschaltung nur noch mit einem über der Frequenz abfallenden Spiegelfaktor K(f) verstärkt wird. Der Verschiebungsstrom fließt im Wesentlichen über den Referenztransistor und den Widerstand im Referenzzweig zur Versorgungsspannung ab.

Diese Maßnahme verringert die wirksame Kollektor-Basis Kapazität der Treiberschaltung, was grundsätzlich zu einer Erhöhung der Steilheit der Stromflanken führt. Dem steht zwar entgegen, dass der frequenzvariable Spiegelfaktor die Flankensteilheit reduziert. In der Summe ergibt sich jedoch durch das Einschalten der Induktivität eine drastische Reduzierung des Einschwingvorgangs (ringing) bei nur geringfügiger Reduktion der Flankensteilheit.

Es ist ein Vorteil dieser Stromspiegelschaltung, dass sie sich monolithisch integrieren lässt. Ein weiterer Vorteil besteht darin, dass sich ein von der Frequenz f abhängiger Spiegelfaktor K(f) durch eine schaltungstechnische Maßnahme realisieren lässt, die eine effektive Kollektor-Basis Kapazität der Transistoren verringert und die darüber hinaus ohne großen Chipflächenbedarf monolithisch integrierbar ist.

Ein weiterer Vorteil bei der Anwendung zum Ansteuern von Laserdioden ist dass der durch die hohe Änderungsgeschwindigkeit des Laserdioden-Stroms an der Laserdiode erzeugte Spannungsabfall nicht mehr in die Versorgungsspannung des Treiberbausteins eingekoppelt wird und damit unerwünschte Beeinflussungen der Ansteuerschaltung reduziert werden oder sogar ganz ausbleiben.

Es ist bevorzugt, dass die Stromspiegelschaltung eine Kapazität aufweist, die den Referenzwiderstand überbrückt.

Diese Merkmale stellen eine weitere schaltungstechnische Maßnahme zur Realisierung eines frequenzabhängigen Spiegelfaktors K(f) dar. Sie verringert die effektive Kollektor-Basis Kapazität der Treiberschaltung substantiell.

Durch das Parallelschaltung der Kapazität wird erreicht, dass der Verschiebungsstrom von der wirksamen Kollektor-Basis-Kapazität der Treiberschaltung nur noch mit einem über der Frequenz abfallenden Spiegelfaktor K(f) verstärkt wird. Der Verschiebungsstrom fließt im Wesentlichen über den Referenztransistor und den Widerstand im zur Versorgungsspannung ab.

Diese Maßnahme verringert die wirksame Kollektor-Basis Kapazität der Treiberschaltung was grundsätzlich zu einer Erhöhung der Steilheit der Stromflanken führt. Dem steht zwar entgegen, dass der frequenzvariable Spiegelfaktor die Flankensteilheit reduziert. In der Summe ergibt sich jedoch durch das Einschalten der Induktivität eine drastische Reduzierung des Einschwingvorgangs (ringing) bei nur geringfügiger Reduktion der Flankensteilheit.

Ferner ist bevorzugt, dass die Kapazität durch mehrere Einzelkapazitäten realisiert ist.

Es hat sich gezeigt, dass diese Ausgestaltung zur Optimierung des Einschwingverhaltens beiträgt, wobei die Induktivität beibehalten werden kann.

Bevorzugt ist auch, dass die Induktivität durch Zwischenschalten einer leitenden Verbindung zwischen den ersten Versorgungsspannungsanschluss und den zweiten Versorgungsspannungsanschluss realisiert wird.

Weiter ist bevorzugt, dass die leitende Verbindung durch einen Bonddraht realisiert ist.

Eine weitere bevorzugte Ausgestaltung zeichnet sich dadurch aus, dass die leitende Verbindung durch eine Streifenleitung auf einer gedruckten Schaltung realisiert ist, die die Stromspiegelschaltung trägt.

Bevorzugt ist ferner, dass der Referenztransistor und der weitere Transistor als bipolare pnp-Transistoren oder p-Kanal-Feldeffekttransistoren ausgeführt sind.

Eine bevorzugte Alternative zeichnet sich dadurch aus, dass der Referenztransistor und der weitere Transistor als bipolare npn-Transistoren oder n-Kanal-Feldeffekttransistoren ausgeführt sind.
Diese Maßnahmen besitzen alle den Vorteil, dass sie in eine monolithisch integrierte Schaltung integriert werden können. ohne zu wesentlichen Vergrößerungen der Chipfläche zu führen.

Schließlich ist auch bevorzugt, dass eine n-Wanne eines pnp-Transistors oder eine p-Wanne eines npn-Transistors über einen Dämpfungswiderstand an ein Bezugspotential angeschlossen ist.

Damit wird erreicht, dass der über die Kapazität des zugehörigen pn-Übergangs fließende Verschiebungsstrom direkt zur Versorgungsspannung abfließen kann. Als Folge wird die häufig als Wanne ausgebildete n- oder p-Schicht auf einem konstanten Potential gehalten wird. Unerwünschte Verschiebungsströme, welche infolge der verhältnismäßig großen Kapazität zwischen Wanne und Substrat auftreten können, werden so klein gehalten. Der Widerstand bewirkt damit eine Verringerung der Güte des im Zusammenhang mit der Induktivität der Zuleitung zu dem elektronischen Bauteil, bspw. zur Laserdiode, entstehenden Schwingkreises. Letztlich führt auch diese Maßnahme zu einer Verringerung der Einschwingvorgänge.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen ,Kombination, sondern auch in anderen Kombinationen oder in Alleinstellung verwendbar sind.

Ausführungsbeispiele der Erfindung sind in den Zeichnungen dargestellt und werden in der nachfolgenden Beschreibung näher erläutert. Es zeigen:
- Figur 1: ein typisches technisches Umfeld der Erfindung in Form einer Schaltung mit einer Versorgungsspannungsquelle, einer Treiberschaltung und einer Laserdiode;
- Figur 2: ein idealisiert vereinfachtes Blockschaltbild einer Treiberschaltung mit einer Stromspiegelschaltung, die keinen frequenzabhängigen Spiegelfaktor aufweist;
- Figur 3: zeitliche Verläufe eines internen Steuerstromsignals und eines idealen Ausgangssignals der Treiberschaltung nach Figur 2;
- Figur 4: Beispiele idealer und realer zeitlicher Verläufe von Ansteuersignalen;
- Figur 5: einen Querschnitt durch einen monolithisch integrierten Transistor der Treiberschaltung nach Figur 2;
- Figur 6: ein Blockschaltbild einer realen Treiberschaltung mit bauteilbedingten Kapazitäten und Induktivitäten;
- Figur 7: ein Blockschaltbild einer realen Treiberschaltung als Ausführungsbeispiel der Erfindung; und
- Figur 8: berechnete zeitliche Verläufe von Ausgangssignalen der Treiberschaltungen nach Figur 6 und Figur 7.

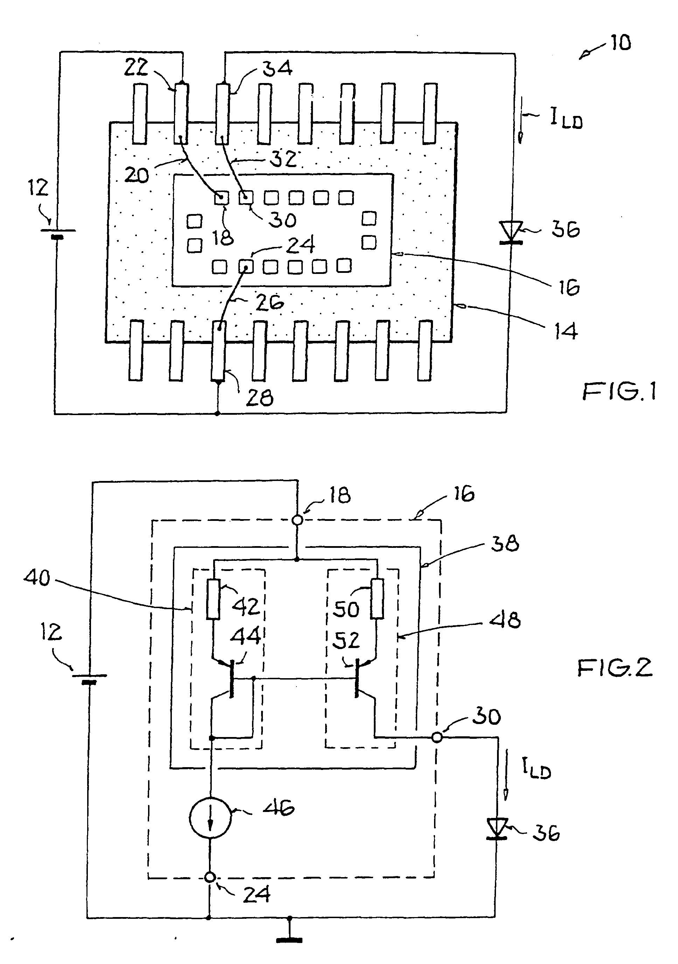

Die Ziffer 10 in der Figur 1 bezeichnet eine Schaltung, insbesondere eine Anwendungsschaltung einer Treiberschaltung für Laserdioden. Die Schaltung 10 weist eine Versorgungsspannungsquelle 12 auf, die einen Treiberbaustein 14 mit einem Treiberchip 16 mit Strom versorgt. Der Treiberchip 16 weist wenigstens einen ersten Versorgungsspannungseingang 18 auf, der über einen Bonddraht 20 mit einem Anschlusspin 22 auf dem Treiberbaustein 14 verbunden ist. Weiter weist der Treiberchip 16 wenigstens einen Masseanschluss 24 auf, der über einen Bonddraht 26 mit einem Anschlusspin 28 auf dem Treiberbaustein 14 verbunden ist. Die beiden Anschlusspins 22 und 28 werden mit verschiedenen Ausgängen der Versorgungsspannungsquelle 12 verbunden, so dass an dem Treiberchip 16 über dessen Versorgungsspannungseingang 18 und Masseanschluss 24 eine Versorgungsspannung anliegt, die von der Versorgungsspannungsquelle 12 bereitgestellt wird.

Weiter weist der Treiberchip 16 wenigstens einen Steuersignalausgang 30 auf, der über einen Bonddraht 32 mit einem Anschlusspin 34 des Treiberbausteins 14 verbunden ist. Zwischen den Anschlusspin 34 und den Anschlusspin 28 des Treiberbausteins 14 ist ein elektronisches Bauteil 36, beispielsweise eine Laserdiode, geschaltet. Die Laserdiode 36 wird daher über den Steuersignalausgang 30 des Treiberchips 16 mit einem Strom I_LD angesteuert. Dabei ist die Schaltung 10 in der Lage, der Laserdiode 36 einen Strom I_LD im Bereich von 0 bis zu einigen 100 mA zu liefern. Die Information, welche Stromstärke zu welcher Zeit eingestellt werden soll, wird dem Treiberchip 16 über weitere Anschlüsse des Treiberbausteins 14 zugeführt oder wird vom Treiberbaustein 14 selbst erzeugt.

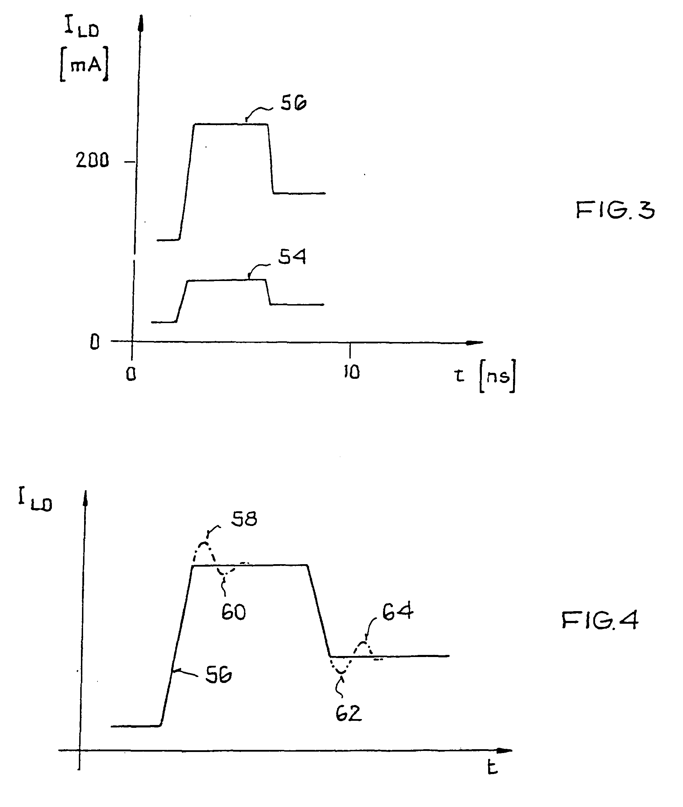

Figur 2 zeigt die Anwendungsschaltung aus der Figur 1 als elektrisches Schaltbild, wobei die Schaltung 10 eine Treiberschaltung 16 aufweist, die eine Stromspiegelschaltung 38 umfasst. Die Bezugsziffer 16 bezeichnet damit sowohl die elektrische Treiberschaltung als auch den physikalischen Treiberchip 16, in den die Treiberschaltung integriert ist. Als Stromspiegel werden im Allgemeinen stromgesteuerte Stromquellen mit Vorzeichenumkehr bezeichnet. Der Stromspiegel 38 nach der Figur 2 weist eine erste Reihenschaltung 40 aus einem Referenzwiderstand 42 und einem als Transistordiode geschalteten Referenztransistor 44 auf. Die erste Reihenschaltung 40 ist zwischen den Versorgungsspannungseingang 18 und eine Steuerstromquelle 46 geschaltet, die den Stromspiegel 38 und damit die an den Steuersignalausgang der Treiberschaltung 16 angeschlossene Laserdiode 36 steuert.

Die Ziffer 48 bezeichnet eine zweite Reihenschaltung aus einem weiteren Widerstand 50 und einem weiteren Transistor 52. Die zweite Reihenschaltung 48 liegt zwischen dem Versorgungsspannungseingang 18 und dem Steuersignalausgang 30 der Treiberschaltung 16. Die Steuerstromquelle 46 steuert sowohl den Referenztransistor 44 als auch den weiteren Transistor 52. Der für die Ansteuerung der Laserdiode 36 benötigte Strom I_LD wird von dem weiteren Transistor 52 bereitgestellt, der in Verbindung mit dem Referenztransistor 44 eine Stromspiegelschaltung 38 realisiert. Die Aufgabe der Stromspiegelschaltung 38 besteht darin, den Steuerstrom I0 um einen möglichst genau definierten Faktor K zu verstärken. Um dies zu erreichen, müssen folgende Bedingungen erfüllt sein.

Zum einen muss der Quotient der Emitterfläche des weiteren Transistors 52 und der Emitterfläche des als Transistordiode geschalteten Referenztransistors 44 den Faktor K ergeben. Weiter muss das Verhältnis der Widerstände 42 und 50 ebenfalls dem Faktor K entsprechen.

Dabei bewirken die Widerstände 42 und 50 eine gleichmäßige Stromaufteilung in den durch jeweils mehrere Emitterfinger realisierten Transistoren 44 und 52. Der weitere Widerstand 50 bewirkt darüber hinaus eine Verringerung des sogenannten Early Effects, der zu einer unerwünschten Abhängigkeit des Ausgangsstroms I_LD von der Kollektor-Emitter-Spannung der Transistoren 44 und 52 führt.

Der Wert von K wird daher durch die verwendeten Transistoren und Widerstände und damit durch die Auslegung der als integrierte Schaltung realisierten Treiberschaltung 16 festgelegt. Dabei wird der Wert von K als Kompromiss aus Anforderungen an den Steuerstrom I0, Anforderungen an die dynamischen Eigenschaften der Treiberschaltung 16 und Anforderungen an die Genauigkeit des Übersetzungsverhältnisses (Verstärkung K) gebildet. In der Regel liegt der Wert von K bei Verwendung einer bipolaren Transistortechnologie zwischen den Werten 4 und 20. Die übrige Schaltung der Treiberschaltung 16 beziehungsweise des Treiberchips 16 wird durch die Steuerstromquelle 46 repräsentiert, die für ein Verständnis der Erfindung hier nicht weiter betrachtet werden muss.

Im Folgenden werden mit Blick auf die Figur 3 zeitliche Verläufe eines internen Steuerstromsignals und eines idealen Ausgangssignals der Treiberschaltung nach Figur 2 betrachtet. Die mit der Ziffer 54 bezeichnete Kurve entspricht dem Verlauf des Steuerstroms 10, wie er von der Steuerstromquelle 46 in Figur 2 ausgegeben wird. Die mit der Ziffer 56 bezeichnete Kurve entspricht dem mit einem Faktor K verstärkten Verlauf des Steuerstroms 10, wie er idealerweise durch die Treiberschaltung 16 bereitgestellt werden soll. Ein solches ideales Verhalten wird dann erreicht, wenn die Anstiegsgeschwindigkeit des Stromes so gering ist, dass der Spannungsabfall U_L über den unvermeidbaren Induktivitäten, der nach dem Gesetz U_L = L · dI/dt auftritt, hinreichend klein ist. Aus analogen Gründen sollte der Verschiebungsstrom I_C an den unvermeidbaren Kapazitäten der Treiberschaltung 16, der bei einer Spannungsänderung U_C über der Kapazität auftritt, hinreichend klein sein. Für I_C gilt bekanntermaßen, dass I_C = C · dU_C/dt ist.

Bei einer Änderung der Stromstärken, wie sie beim Ansteuern von Laserdioden in Verbindung mit dem Beschreiben von CDs oder DVDs auftreten, sind diese Bedingungen jedoch nicht erfüllt. Bei realen Schaltungen treten Einschwingvorgänge auf. Die durchgezogen gezeichnete Kurve 56 in der Figur 4 entspricht der Kurve 56 in der Figur 3, also dem gewünschten oder idealen Verlauf des Ausgangssignals der Treiberschaltung 16. Durch die genannten Induktivitäten und Kapazitäten sind diesem idealen Verlauf 56 jedoch Überschwinger 58, 64 und Unterschwinger 60, 62 überlagert, welche die Genauigkeit der Steuerung des elektronischen Bauteils 36, beispielsweise einer Laserdiode zum Beschreiben von CDs oder DVDs, beeinträchtigt.

Die störenden Induktivitäten befinden sich sowohl im Treiberbaustein 14 in der Form von Bonddrahtinduktivitäten und Gehäuseinduktivitäten, als auch außerhalb in den Zuführungsleitungen für die Versorgungsspannung und für die Versorgung der Laserdiode 36. Diese Induktivitäten sind mit der heutigen Aufbautechnik nicht vollständig zu vermeiden. Werte für die Bonddrahtinduktivitäten liegen im Bereich von etwa 1 nH.

Werte von einigen wenigen nH sind für die Anschlussleitungen zur Laserdiode 36 typisch. Auch die Zuführung der Versorgungsspannung zum Treiberbaustein 14 und zu dem Treiberchip 16 sind mit Induktivitäten behaftet.

Diese Induktivitäten bilden mit Kapazitäten der Schaltung 10 Schwingkreise, die zu den in Figur 4 dargestellten Einschwingvorgängen (Überschwinger 58, 64, Unterschwinger 60, 62) führen. Dabei werden die Kapazitäten hauptsächlich von dem als Treibertransistor arbeitenden weiteren Transistor 52 gebildet. Weitere Kapazitäten ergeben sich aus Leitungskapazitäten, beispielsweise aus Kapazitäten der Leiterbahnen zum Anschluss der Laserdiode entsprechend Schaltung 10.

Die Eigenresonanzfrequenzen der Schwingkreise sind dabei im Allgemeinen unterschiedlich, so dass sich durch Überlagerung verschiedener Eigenresonanzfrequenzen verschiedener Schwingkreise unterschiedliche Formen des Stromverlaufs ergeben können. Dabei hängt die Höhe der Abweichungen, also das Ausmaß der Abweichung der Einschwingvorgänge nach der Figur 4 vom idealen Verlauf 56 von der Güte des angeregten Schwingkreises ab.

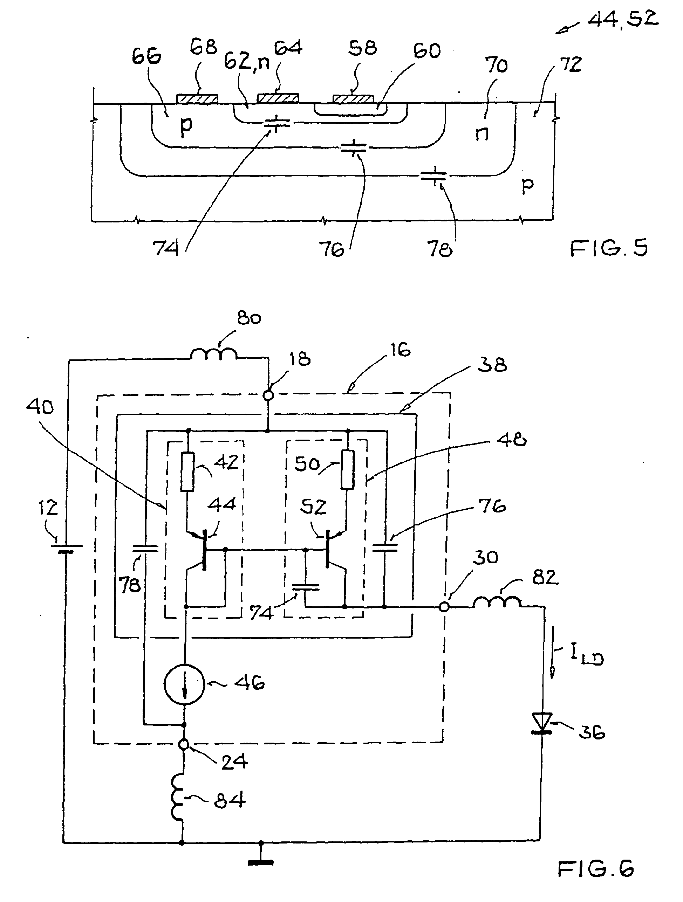

Figur 5 zeigt einen Querschnitt durch einen monolithisch integrierten Transistor 44, 52 der Treiberschaltung 16 nach der Figur 2. Der dargestellte Transistor ist ein bipolarer pnp-Transistor mit einem metallischen Emitteranschluss 58 auf einer p-dotierten Emitterschicht 60. Die Schicht 60 ist in eine n-dotierte Basisschicht 62 eingebettet, die von einem metallischen Basiskontakt 64 kontaktiert wird. Die Basisschicht 62 liegt in einer p-dotierten Kollektorschicht 66, die von einem metallischen Kollektoranschluss 68 kontaktiert wird. Dieser Schichtaufbau ist in eine isolierende n-dotierte Wanne 70 eingebettet, die wiederum in einem p-leitenden Substrat 72 liegt.

In den Schichten, in denen die Ladungsträgerkonzentration von einer ersten Konzentration in eine zweite Konzentration übergeht, bilden sich unvermeidbare Kapazitäten 74, 76 des dargestellten pnp-Transistors aus. Die Ziffer 74 bezeichnet eine solche unvermeidbare Kollektor-Basis-Kapazität. Analog bezeichnet die Ziffer 76 die unvermeidbare Kapazität zwischen der Kollektorschicht 66 und der n-Wanne 70 und die Ziffer 78 bezeichnet die unvermeidbare Kapazität zwischen der n-Wanne 70 und dem p-Substrat 72. Mit Blick auf ein günstiges Einschwingverhalten sind sowohl die parasitären Induktivitäten als auch die parasitären Kapazitäten möglichst zu minimieren. Bei gegebener Herstellungstechnologie und gegebenen, für die Ansteuerung des elektronischen Bauteils 36 erforderlichen Stromstärken sind die in der Figur 5 eingezeichneten Kapazitäten nicht weiter zu verkleinern. Allerdings ist ihr Einfluss auf das Einschwingverhalten durch geeignete Schaltungsmaßnahmen beeinflussbar. Dies gilt insbesondere für die Kapazität 74 des Kollektor-Basis-Übergangs.

Figur 6 zeigt die Schaltungsanordnung nach Figur 2 mit Ergänzungen durch Leitungsinduktivitäten und Transistorkapazitäten, wie sie bei einer realen Schaltung auftreten. Dazu gehört insbesondere die Induktivität 80 der Versorgungsleitung zwischen Versorgungsspannungsquelle 12 und Versorgungsspannungseingang 18, eine Induktivität 82 der Ansteuerleitung zwischen dem Steuersignalausgang 30 der Treiberschaltung 16 und der anzusteuernden Laserdiode 36 sowie die Induktivität 84 des Masseanschlusses 24 der Treiberschaltung 16. Die Kollektor-Basis-Kapazität 74 wirkt sich insbesondere beim weiteren Transistor 52, also dem Treibertransistor, aus. Sie ist daher in der Figur 6 zwischen den Steuereingang (Basis) des weiteren Transistors 52 und dessen Kollektor eingezeichnet. Die Kollektor-Wannen-Kapazität 76 liegt im Schaltbild der Figur 6 parallel zu der zweiten Reihenschaltung 48 aus weiterem Widerstand 50 und weiterem Transistor 52. Die Wannen-Substrat-Kapazität 78 liegt im Schaltbild der Figur 6 zwischen dem Versorgungsspannungseingang 18 und dem Masseanschluss 24.

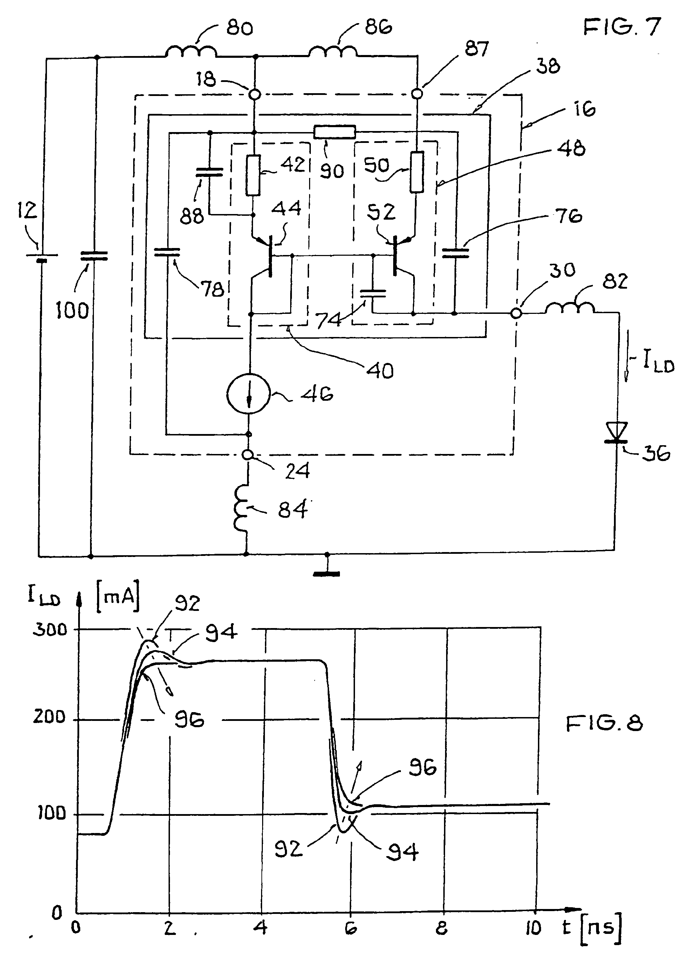

Im Folgenden werden mit Blick auf die Figur 7 schaltungstechnische Maßnahmen vorgestellt, die das Einschwingverhalten in erwünschter Weise beeinflussen, indem sie einen frequenzabhängigen Verstärkungsfaktor K der Stromspiegelschaltung 38 erzeugen.

Durch die Realisierung eines frequenzabhängigen Spiegelfaktors K(f) kann die effektive Kollektor-Basis-Kapazität 74 substantiell verringert werden.

Im Rahmen der Ausgestaltung nach der Figur 7 wird dies durch Einfügen der Induktivität 86 in die Verbindung der Versorgungsleitungsinduktivität 80 mit der zweiten Reihenschaltung 48 aus weiterem Widerstand 50 und weiterem Transistor (Treibertransistor) 52 erzielt. Die Induktivität 86 kann außerhalb der Treiberschaltung 16 geschaltet werden, so dass die Induktivität 86 mit einem zweiten Versorgungsspannungseingang 87 der Treiberschaltung 16 verbunden wird. Die Induktivität 86 kann damit beispielsweise als Bonddraht realisiert werden.

Alternativ oder ergänzend zum Einschalten einer Induktivität 86 kann eine Kapazität 88 parallel zum Referenzwiderstand 42 geschaltet werden. Damit wird der Verschiebungsstrom der Kollektor-Basis-Kapazität 74 nur noch mit dem über der Frequenz abfallenden Spiegelfaktor K(f) verstärkt. Mit anderen Worten: Es wird ausgenutzt, dass die Wirkung der Kollektor-Basis-Kapazität 74 mit dem Spiegelverhältnis K(f) skaliert. Mit anderen Worten: Im Rahmen der speziellen Beschaltung nach der Figur 7 ist die effektive Kapazität des Kollektor-Basis-Übergangs proportional zu der Kollektor-Basis-Kapazität 74. Der dieser Kollektor-Basis-Kapazität 74 zugeordnete Verschiebungsstrom fließt dann im Wesentlichen über den Referenztransistor 44 und den Referenzwiderstand 42 zur Versorgungsspannung ab. Wie bereits weiter oben erwähnt, verringert diese Maßnahme die wirksame Kollektor-Basis-Kapazität 74 und führt damit grundsätzlich zu einer Erhöhung der Steilheit der Stromflanken. Die Steilheit der Stromflanken wird andererseits durch den frequenzvariablen K-Faktor reduziert. In der Summe führt die Einschaltung der Induktivität 86 und/oder die Einschaltung der Kapazität 88 in der beschriebenen Weise zu einer drastischen Reduzierung des Einschwingvorgangs (ringing) bei nur geringfügiger Reduktion der Flankensteilheit. Ein weiterer Vorteil besteht darin, dass der durch die hohe Änderungsgeschwindigkeit des Laserdiodenstroms I_LD an der Laserdiode 36 erzeugte Spannungsabfall nicht mehr in die Versorgungsspannung des Treiberbausteins 14 eingekoppelt wird. Unerwünschte Beeinflussungen der Ansteuerschaltung durch den genannten Spannungsabfall werden damit vermieden.

Figur 7 zeigt darüber hinaus, dass die Kollektor-Wannen-Kapazität 76, also die zur Isolation der Transistoren benötigte n-Wanne 70, über einen Widerstand 90 an den Versorgungsspannungseingang 18 angeschlossen wurde. Als Folge wird erreicht, dass der über die Kollektor-Wannen-Kapazität 76 fließende Verschiebungsstrom direkt zur Versorgungsspannung abfließen kann. Dadurch wird insbesondere erreicht, dass die n-Wanne 70 auf konstantem Potential gehalten wird. Unerwünschte Verschiebungsströme, die sonst als Folge der verhältnismäßig großen Kapazität 78 zwischen Wanne 70 und Substrat 72 auftreten könnten, werden so klein gehalten. Der Widerstand 90 hat in diesem Zusammenhang die Funktion, die Güte des in Verbindung mit der Induktivität 82 der Ansteuerleitung entstehenden Schwingkreises zu verringern, was die Amplitude der Einschwingvorgänge gering hält. Der in Figur 7 dargestellte Stützkondensator 100 verringert den Einfluss der Bonddrahtinduktivitäten 80 in der Zuführung der Versorgungsspannung für den Treiberchip die Treiberschaltung 16.

Figur 8 zeigt zeitliche Verläufe des Ansteuerstroms I_LD für die Laserdiode 36, wie sie für verschiedene Werte der Induktivität 86 berechnet wurden. Dabei entspricht die Kurve 92 einer nicht vorhandenen Induktivität 86. Die Kurve 94 wurde mit einem Wert von 300 pH für die Induktivität 86 bei einer Induktivität 82 der Ansteuerleitung von 3 nH berechnet. Wie aus Figur 8 ersichtlich ist, verringert das Einschalten einer solchen Induktivität 86 mit 300 pH die Amplitude der Einschwingvorgänge. Eine weitere Verringerung ergibt sich durch Einschalten einer Induktivität von 86 von 600 pH. Das Ergebnis für diesen Wert ist durch die Kurve 96 repräsentiert. Wie aus dem Verlauf der Kurve 96 ersichtlich ist, können die Einschwingvorgänge bei fast gleichbleibender Flankensteilheit fast völlig vermieden werden.

Vergleichbare Ergebnisse erhält man beim Einschalten einer Kapazität 88 in der in der Figur 7 dargestellten Weise. Weiter erhält man vergleichbare Ergebnisse bei einer Kombination einer Kapazität 88 mit einer Induktivität 86. Letztlich hängt die Dimensionierung der Schaltung und damit die Dimensionierung der Kapazität 88 und/oder der Induktivität 86 von den technischen Randbedingungen wie der Bonddrahtlänge, der Induktivität der Last (der Laserdiode 36) sowie den Anforderungen an die Anstiegszeiten und Abfallzeiten des Ansteuersignals ab.

Die Erfindung wurde weiter oben zwar für geerdete Laserdioden 36 beschrieben, die eine Stromspiegelschaltung 38 aus pnp-Transistoren 44 und 52 benötigen. Es versteht sich aber, dass das Prinzip der Erfindung ebenso gut auf Stromspiegelschaltungen mit npn-Transistoren anwendbar ist. Die Laserdiode 36 wird in diesem Fall gegen eine positive Spannung geschaltet. Analog kann die Erfindung auch bei Schaltungen in CMOS-Technik angewendet werden.

## Patentansprüche

1. Treiberschaltung (16) zum Betreiben eines elektronischen Bauteils (36) mit einem elektrischen veränderlichen Strom, der in gesteuerter Weise zwischen wenigstens zwei diskreten Stromstärken umgesteuert wird, wobei die Treiberschaltung (16) eine Stromspiegelschaltung (38) umfasst und die Stromspiegelschaltung (38)
eine erste Reihenschaltung (40) aus einem Referenzwiderstand (42) und einem Referenztransistor (44) zwischen einem ersten Versorgungsspannungsanschluss (18) und einer Steuerstromquelle (46) umfasst sowie
eine zweite Reihenschaltung (48) aus einem weiteren Widerstand (50) und einem weiteren Transistor (52) zwischen einem zweiten Versorgungsspannungsanschluss (87) und einem Ausgang (30) der Stromspiegelschaltung (38) umfasst, über den das elektronische Bauteil (36) angesteuert wird,
wobei sowohl der Referenztransistor (44) als auch der weitere Transistor (52) durch eine gemeinsame Steuerstromquelle (46) gesteuert werden,
**dadurch gekennzeichnet, dass**
die Treiberschaltung (16) Schaltungselemente aufweist, die Einschwingvorgänge dämpfen, die beim Umsteuern des elektrischen veränderlichen Stroms zwischen den wenigstens zwei diskreten Stromstärken auftreten, und
die Stromspiegelschaltung (38) eine in Reihe mit dem weiteren Widerstand (50) geschaltete Induktivität (86) aufweist.

2. Treiberschaltung (16) nach Anspruch 1, **dadurch gekennzeichnet, dass** die Stromspiegelschaltung (38) eine Kapazität (88) aufweist, die den Referenzwiderstand (42) überbrückt.

3. Treiberschaltung (16) nach Anspruch 2, **dadurch gekennzeichnet, dass** die Kapazität (88) durch mehrere Einzelkapazitäten realisiert ist.

4. Treiberschaltung (16) nach einem der vorhergehenden Ansprüche, **dadurch gekennzeichnet, dass** die Induktivität (86) durch Zwischenschalten einer leitenden Verbindung zwischen den ersten Versorgungsspannungsanschluss (18) und den zweiten Versorgungsspannungsanschluss (87) realisiert wird.

5. Treiberschaltung (16) nach Anspruch 4, **dadurch gekennzeichnet, dass** die leitende Verbindung durch einen Bonddraht realisiert ist.

6. Treiberschaltung (16) nach Anspruch 4, **dadurch gekennzeichnet, dass** die leitende Verbindung durch eine Streifenleitung auf einer gedruckten Schaltung realisiert ist, die die Stromspiegelschaltung (38) trägt.

7. Treiberschaltung (16) nach einem der vorhergehenden Ansprüche, **dadurch gekennzeichnet, dass** der Referenztransistor (44) und der weitere Transistor (52) als bipolare pnp-Transistoren oder p-Kanal-Feldeffekttransistoren ausgeführt sind.

8. Treiberschaltung (16) nach einem der Ansprüche 1 bis 6, **dadurch gekennzeichnet, dass** der Referenztransistor (44) und der weitere Transistor (52) als bipolare npn-Transistoren oder n-Kanal-Feldeffekttransistoren ausgeführt sind.

9. Treiberschaltung (16) nach einem der Ansprüche 7 oder 8, **dadurch gekennzeichnet, dass** eine n-Wanne eines pnp-Transistors oder eine p-Wanne eines npn-Transitors über einen Dämpfungswiderstand (90) an ein Bezugspotential angeschlossen ist.

## Claims

1. Driver circuit (16) for operating an electronic component (36) with an electrically variable current, which can be changed over in controlled manner between at least two discrete current intensities, wherein the driver circuit (16) comprises a current mirror circuit (39) and the current mirror circuit (38) comprises a first series circuit (40) consisting of a reference resistor (42) and a reference transistor (44) between a first supply voltage terminal (18) and a control current source (46) as well as comprises a second series circuit (48) consisting of a further resistor (50) and a further transistor (52) between a second supply voltage terminal (87) and an output (30) of the current mirror circuit (38), by way of which the electronic component (36) is controlled in drive, wherein not only the reference transistor 44, but also the further transistor (52) are controlled by a common control current source (46), **characterised in that** the driver circuit (16) comprises circuit elements which damp transient phenomena arising in the case of changeover of the electrically variable current between the at least two discrete current intensities and the current mirror circuit (38) comprises an inductance (86) connected in series with the further resistor (50).

2. Driver circuit (16) according to claim 1, **characterised in that** the current mirror circuit (38) has a capacitor (88) bridging over the reference resistor (42).

3. Driver circuit (16) according to claim 2, **characterised in that** the capacitor (88) is realised by several individual capacitors.

4. Driver circuit (16) according to one of the preceding claims, **characterised in that** the inductance (86) is realised by interposition of a conductive connection between the first supply voltage terminal (18) and the second supply voltage terminal (87).

5. Driver circuit (16) according to claim 4, **characterised in that** the conductive connection is formed by a bond wire.

6. Driver circuit (16) according to claim 4, **characterised in that** the conductive connection is realised by a strip conductor on a printed circuit, which carries the current mirror circuit (38).

7. Driver circuit (16) according to one of the preceding claims, **characterised in that** the reference transistor (44) and the further transistor (52) are executed as bipolar pnp-transistors or p-channel field effect transistors.

8. Driver circuit (16) according to one of claims 1 to 6, **characterised in that** the reference transistor (44) and the further transistor (52) are executed as bipolar npn-transistors or n-channel field effect transistors.

9. Driver circuit (16) according to one of claims 7 and 8, **characterised in that** an n-trough of a pnp-transistor or a p-trough of an npn-transistor is connected with a reference potential by way of a damping resistor (90).

## Revendications

1. Montage excitateur (16) pour la commande d'un composant électronique (36) par un courant électrique alternatif, qui est commuté de façon commandée entre au moins deux intensités discrètes de courant, dans lequel le montage excitateur (16) comporte un circuit de commutation par miroir de courant (38) et dans lequel le circuit de commutation par miroir de courant (38) se compose
d'un premier circuit de commutation série (40), constitué d'une résistance de référence (42) et d'un transistor de référence (44), entre un premier branchement de tension d'alimentation (18) et une source de courant (46), ainsi que
d'un deuxième circuit de commutation série (48), constitué d'une autre résistance (50) et d'un transistor supplémentaire (52), entre un deuxième branchement de tension d'alimentation (87) et une sortie (30) du circuit de commutation par miroir de courant (38), à travers lequel le composant électronique (36) est commandé,
montage dans lequel aussi bien le transistor de référence (44) que le transistor supplémentaire (52) sont pilotés par une source de courant (46) commune,
**caractérisé en ce que**
le montage excitateur (16) présente des éléments de commutation qui amortissent les processus d'oscillation apparaissant lors de la commutation du courant électrique variable entre les au moins deux intensités de courant discrètes et **en ce que**
le circuit de commutation par miroir de courant (38) présente une inductance (86) montée en série avec l'autre résistance (50).

2. Montage excitateur (16) selon la revendication 1, **caractérisé en ce que** le circuit de commutation par miroir de courant (38) comporte une capacité (88) en dérivation sur la résistance de référence (42).

3. Montage excitateur (16) selon la revendication 2, **caractérisé en ce que** la capacité (88) est formée de plusieurs capacités individuelles.

4. Montage excitateur (16) selon l'une quelconque des revendications précédentes, **caractérisé en ce que** l'inductance (86) est formée par l'interconnexion d'une liaison conductrice entre le premier branchement de tension d'alimentation (18) et le deuxième branchement de tension d'alimentation de courant (87).

5. Montage excitateur (16) selon la revendication 4, **caractérisé en ce que** la liaison conductrice est réalisée sous la forme d'un fil de liaison.

6. Montage excitateur (16) selon la revendication 4, **caractérisé en ce que** la liaison conductrice est réalisée sous la forme d'une bande conductrice sur un circuit imprimé, qui porte le circuit de commutation par miroir de courant (38).

7. Montage excitateur (16) selon l'une quelconque des revendications précédentes, **caractérisé en ce que** le transistor de référence (44) et le transistor supplémentaire (52), sont des transistors bipolaires pnp ou des transistors à effet de champ à canal p.

8. Montage excitateur (16) selon l'une quelconque des revendications 1 à 6, **caractérisé en ce que** le transistor de référence (44) et le transistor supplémentaire (52) sont des transistors bipolaires npn ou des transistors à effet de champ à canal n.

9. Montage excitateur (16) selon l'une quelconque des revendications 7 ou 8, **caractérisé en ce que** la cuvette n d'un transistor pnp, ou la cuvette p d'un transistor npn, est reliée à un potentiel de référence à travers une résistance tampon (90).
